# EUROPÄISCHE PATENTSCHRIFT

(11) **EP 1 336 227 B1**
(45) Veröffentlichungstag und Bekanntmachung des Hinweises auf die Patenterteilung: **03.10.2007**
(21) Anmeldenummer: 01955383.3
(22) Anmeldetag: 02.08.2001
(51) Int. Cl.: H01R 13/24, H01H 9/02

(54) **ELEKTRISCHE ANORDNUNG**
ELECTRICAL ARRANGEMENT
SYSTEME ELECTRIQUE

(30) Priorität: 23.11.2000 DE 10058287
(43) Veröffentlichungstag der Anmeldung: 20.08.2003
(73) Patentinhaber: Moeller GmbH, 53115 Bonn (DE)
(72) Erfinder: SCHÄFER, Jörg, 53359 Rheinbach (DE); WOLFF, Bernd, 53773 Hennef (DE); VOLBERG, Jürgen, 53844 Troisdorf (DE)
(74) Vertreter: Mäder, Winfried
(86) Internationale Anmeldenummer: PCT/EP2001/008960
(87) Internationale Veröffentlichungsnummer: WO 2002/043189

(56) Entgegenhaltungen:
- EP-A- 0 996 197
- DE-A- 3 014 639
- DE-U- 9 214 324
- DE-U- 29 504 491

## Beschreibung

Die Erfindung betrifft eine elektrische Anordnung nach dem Oberbegriff des Anspruchs 1.

Es sind bereits Befehls- beziehungsweise Meldegeräte gemäß dem Oberbegriff des Anspruchs 1 hinlänglich bekannt. So beschreibt beispielsweise die Informationsschrift der Fa. Moeller ("Befehls- und Meldegeräte RMQ 16 und RMQ 22, Auswahlhilfe", AH 116-006 D 9/98) gattungsgemäße Geräte.

Des Weiteren ist aus der DE 30 14 639 A1 ein gattungsgemäßes Befehls- und Meldegerät mit herkömmlicher Anschlußtechnik bekannt. Bei diesem Gerät ist darüber hinaus noch ein elektrisch und mechanisch ankoppelbares Transformatorelement zur Stromversorgung der Beleuchtungsmittel vorgesehen.

Diese Geräte sind ausschließlich für die konventionelle Verdrahtung vorgesehen. Um sie an ein Bussystem zu koppeln, werden bislang mehrere Geräte in einem Aufbaugehäuse zusammengefasst, über eine separate Platine verdrahtet und über eine gemeinsame Leitung an das Bussystem angeschlossen.

Darüber hinaus sind durch die DE 295 04 491.8 U1 und die DE 92 14 324.5 U1 gattungsfremde Geräte der Hausinstallationstechnik bekannt.

Ferner existieren bereits spezielle busfähige Befehlsgeräte. Diese Geräte sind aber sehr aufwendig hergestellt und auch nur für den Anschluß an ein einziges Bussystem geeignet. Bekannt sind derartige Geräte aus dem Hauptkatalog der Fa. Moeller ("Automatisierungssysteme, Antriebstechnik" gültig ab Oktober 2000, HPL0213-2001D, 8/00, S. 09/002, 09/003, 09/006).

Der Erfindung liegt die Aufgabe zugrunde eine elektrische Anordnung zu schaffen, die bei reduziertem Herstellungsaufwand eine verbesserte Funktionalität aufweist.

Ausgehend von Geräten der eingangs genannten Art wird die Aufgabe erfindungsgemäß durch die kennzeichnenden Merkmale des unabhängigen Anspruchs gelöst, während den abhängigen Ansprüchen vorteilhafte Weiterbildungen der Erfindung zu entnehmen sind.

Gemäß der Erfindung weist das gattungsbildende Befehls- und/oder Meldegerät, im folgenden der Einfachheit halber nur noch Befehlsgerät genannt, ein Koppelmodul zur Anbindung an ein Bussystem auf. Dabei umfasst die Koppeleinheit in einem Gehäuse eine Logikeinheit zur elektrischen Anbindung des Befehlsgerätes an das Bussystem. Hierfür weist das Koppelmodul auf seiner dem Befehlsgerät zugekehrten Seite sowohl mechanische als auch elektrische Verbindungsmittel und auf seiner dem Bussystem zugekehrten Seite, insbesondere als Steckerverbindung ausgeführte Busanschlußmittel auf. Auch ist das Koppelmodul lösbar, vorzugsweise über Rastmittel mit dem Befehlsgerät verbunden. Hierbei weist das Gehäuse des Koppelmoduls an einer Seite feststehende Hintergriffe und auf seiner gegenüberliegenden Seite mindestens einen federbeweglich ausgebildeten Rastarm auf. In einer bevorzugten Ausführung sind drei Hintergriffe und gegenüberliegend ein beweglicher Rastarm mit entsprechend drei den Hintergriffen direkt gegenüberliegend ausgebildeten Rastvorsprünge gebildet. Hierdurch wird erreicht, dass bis zu drei einzelne Funktionselemente wie Kontaktelemente (Öffner, Schließer - auch zwangsgeführt) oder Leuchtelemente mit dem Koppelmodul verbindbar sind. Die elektrische Verbindung erfolgt vorzugsweise über aus dem Koppelmodul herausgeführte Kontaktfedern die bei Zusammensetzung von Koppelmodul und Befehlsgerät in die Schraubendreheröffnungen der Funktionselemente hineinragen und diese dort über die Schraubköpfe der Anschlußklemmen kontaktieren. Durch die Erfindung können herkömmliche Befehls- und /oder Meldegeräte, die bislang konventionell verdrahtet werden mußten an ein Bussystem angekoppelt werden. Durch die erfindungsgemäße Anordnung können ferner die Geräte in ihrer jeweiligen Funktion durch Austausch von einzelnen Funktionselementen variiert werden und die Geräte wahlweise oder in Kombination konventionell oder über Bussystem kontaktiert werden. Wird eine kombinierte Kontaktierung gewünscht ist - um Fehlfunktionen zu vermeiden - darauf zu achten, dass keine Doppelkontaktierung (Bus und konventionell) erfolgt.

Weitere Einzelheiten und Vorteile der Erfindung ergeben sich aus dem folgenden, anhand von Figuren erläuterten Ausführungsbeispiel. Es zeigen
- Figur 1:: die erfindungsgemäße elektrische Anordnung in einer Perspektivansicht;
- Figur 2:: die Anordnung gemäß Fig. 1 mit Funktionselement ohne Seitendeckel; und
- Figur 3:: das Koppelmodul aus Fig. 1 in einer Perspektivansicht.

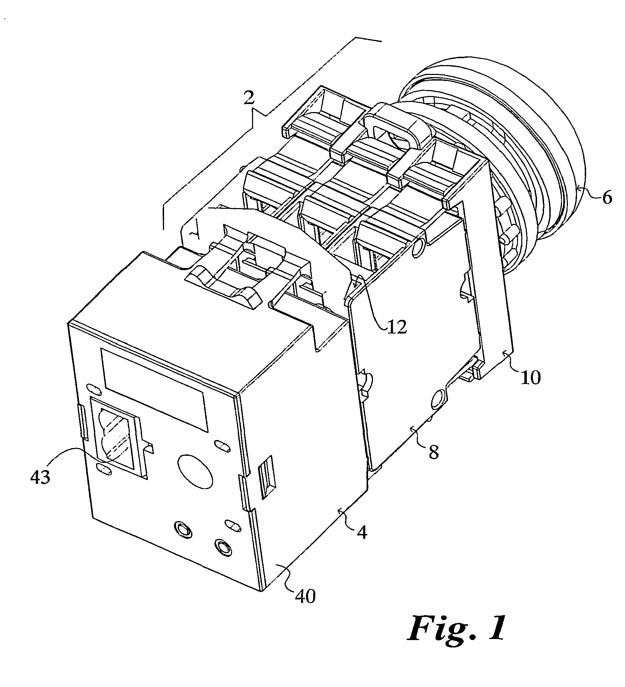

Nach Fig. 1 umfasst die erfindungsgemäße elektrische Anordnung im wesentlichen ein Befehls- und/oder Meldegerät 2 und ein mit diesem lösbar verbundenes Koppelmodul 4. Im dargestellten Ausführungsbeispiel ist ein als Leuchtdrucktaste ausgebildetes Befehls- und Meldegerät dargestellt.

Dieses besteht im wesentlichen aus einem als beleuchtete Drucktaste ausgebildeten Frontelement 6, drei Funktionselementen 8 und einem das Frontelement 6 und die Funktionselemente 8 verbindenden Befestigungselement 10. Als Funktionselemente 8 sind zum Beispiel ein Öffner-Kontaktelement zur Trennung des Stromkreises, ein Schließer-Kontaktelement zur Fernmeldung eines Ausgelöstsignals und ein Leuchtelement zur Ausgelöstmeldung vor Ort angebracht. Die Kombination von einzelnen Funktionselementen 8 ist je nach gewünschter Funktion frei variierbar.

Die Funktionselemente 8 sind vorzugsweise zumindest was die äußeren Konturen des Gehäuseteils angeht gleich ausgebildet. Sie weisen im wesentlichen flache quaderförmige Gehäuseteile auf, die auf ihrer oberen schmalen Stirnseite Öffnungen für Betätigungsstößel oder Leuchtelemente, auf ihren seitlichen Schmalseiten einander gegenüberliegende Kabeleinführöffnungen zu den Anschlußstellen insbesondere Schraubklemmen (für die konventionelle Verdrahtung) und auf der unteren Schmalseite Einführöffnungen für Schraubendreher zur Betätigung der Schraubklemmen aufweisen. In der vorliegenden Ausführungsform ist unterhalb jeder Kabeleinführöffnung eine Rastvertiefung 12 zur Befestigung des Koppelmoduls 4 ausgebildet.

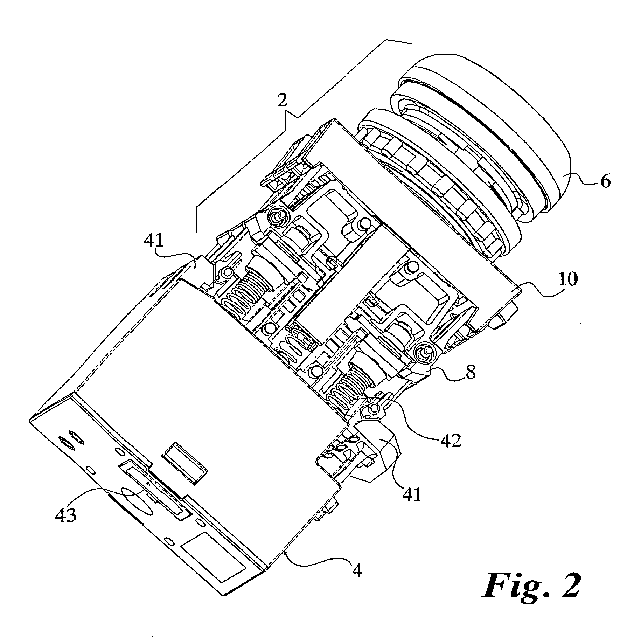

Das Koppelmodul 4 umfasst ein quaderförmiges Gehäuse 40, welches auf seiner Oberseite mechanische Verbindungsmittel 41 (Fig. 2 u. 3) zur lösbaren Befestigung des Koppelmoduls 4 an dem mindestens einen Funktionselement 8 sowie elektrische Verbindungsmittel 42 zur elektrischen Kontaktierung zwischen Koppelmodul 4 und dem mindestens einen Funktionselement 8 aufweist. Dabei umfassen die mechanischen Verbindungsmittel 41 auf einer Seite vorzugsweise drei jeweils über einen Freiraum 41 a voneinander beabstandete feststehende Hintergriffe 41b sowie auf der gegenüberliegenden Seite einen federnd beweglich ausgebildeten Rastarm mit drei jeweils über einen Freiraum 41a voneinander beabstandeten Rastvorsprüngen 41c. Vorzugsweise weist der Rastarm Mittel 41d zum Angriff eines Werkzeuges auf, mit dessen Hilfe der Rastarm zur Entriegelung einer Rastverbindung verbiegbar ist. Bevorzugt sind diese Mittel 41 d als schlitzförmige Aufnahme zum Eingriff eines Schraubendrehers ausgeführt. Denkbar sind allerdings auch andere Mittel 41 d wie Fortsätze zur Handbetätigung. Die Rastvorsprünge 41c und die Hintergriffe 41b sind kopfseitig mit zur Oberfläche des Koppelmoduls 4 hin abfallenden Schrägflächen ausgebildet, so dass durch ein einfaches Aufeinanderdrücken von Befehls- und/oder Meldegerät 2 und Koppelmodul 4 diese durch eine mechanische Rastverbindung miteinander verbindbar sind.

Die elektrischen Verbindungsmittel 42 sind mit Vorteil durch Kontaktfedern gebildet, die im Gehäuseinneren die elektrische Verbindung zur Logikeinheit darstellen. Vorzugsweise sind die Kontaktfedern kraftformschlüssig und lösbar im Gehäuse fixierbar, so dass zum einen eine sichere Kontaktierung und zum anderen durch Hinzufügen oder Herausnehmen der Kontaktfedern eine einfache Erweiterung oder Verminderung von Kontaktstellen ermöglicht wird. In einer bevorzugten Ausführung hat das Koppelmodul 4 die Breite von drei Funktionselementen 8 und weist insgesamt sechs Öffnungen zur Aufnahme bzw. Durchführung der Kontaktfedern auf. Dabei sind die Öffnungen derart positioniert, dass die Kontaktfedern bei Befestigung des Koppelmoduls 4 an den Funktionselementen 8 des Befehls- und Meldegerätes direkt in die Schraubendreher-Einführöffnungen der Funktionsmodule hineinragen und dort auf die Schraubköpfe der Anschlußklemmen der Funktionselemente 8 drücken und so eine elektrisch leitende Verbindung zwischen Koppelmodul 4 und den Funktionselementen 8 gewährleisten. Zur mechanischen Befestigung des Koppelmoduls 4 wird dieses entweder von unten i.w. parallel auf die Unterseite der Funktionselemente 8 aufgedrückt oder mit seinen feststehenden Hintergriffen 41b in die Rastvertiefung 12 auf einer Seite der Funktionselemente 8 eingehakt und Richtung Funktionselemente 8 eingeschwenkt bis der gegenüberliegende Rastarm des Koppelmoduls 4 mit seinen Rastvorsprüngen 41c in die gegenüberliegenden Rastvertiefungen 12 der Funktionselemente 8 einrastet. Hierdurch wird im wesentlichen zeitgleich eine mechanische und elektrische Verbindung hergestellt.

Um die Berührungssicherheit der elektrischen Anordnung hinsichtlich der seitlichen Kabeleinführöffnungen der Funktionselemente 8 zu gewährleisten und ein gleichzeitiges konventionelles Anschliessen der Funktionsmodule zu verhindern sind die Hintergriffe 41b und die Rastvorsprünge 41c des Rastarms derart ausgebildet, dass die Kabeleinführöffnungen bei montierter Koppeleinheit 4 verschlossen sind. Hierfür können die Hintergriffe 41b bzw. die Rastvorsprünge 41c mit schildartigen Fortsätzen ausgebildet sein. In einer anderen Ausführung können die Hintergriffe 41b und die Rastvorsprünge 41c zwecks Befestigung des Koppelmoduls 4 auch unmittelbar in die Kabeleinführöffnungen der Funktionselemente 8 eingreifen und so eine Berührungssicherheit gewährleisten.

Die Fig. 2 zeigt die erfindungsgemäße Anordnung gemäß Fig. 1, wobei ein seitlich befestigtes Funktionselement 8 kein Deckelteil aufweist. Hier ist deutlich erkennbar, dass bei montierter Koppeleinheit 4 die feststehenden Hintergriffe 41b und die gegenüber angeordneten Rastvorsprünge 41c des Rastarms in die unterhalb der Kabeleinführöffnungen der Funktionselemente 8 befindlichen Rastvertiefungen 12 einer jeden Seite der Funktionselemente 8 eingreifen. Auch ist die Kontaktierung zwischen Koppelmodul 4 und den Funktionselementen 8 durch die auf die Schraubköpfe der Anschlußklemmen der Funktionselemente 8 drückenden Kontaktfedern erkennbar.

In Fig. 1 und 2 sind weiterhin die Busanschlußmittel 43 in Form einer Anschlußbuchse zur Aufnahme eines Steckerteils dargestellt.

Mit Vorteil soll die Anbindung an ein serielles Bussystem, insbesondere AS-i oder Profibus realisiert werden. Hierfür sind natürlich auch entsprechende andere Busanschlußmittel vorgesehen, wie Messerkontaktanschlüsse an eine AS-i-Zweidrahtleitung oder einfache Schraubanschlüsse oder dergleichen mehr.

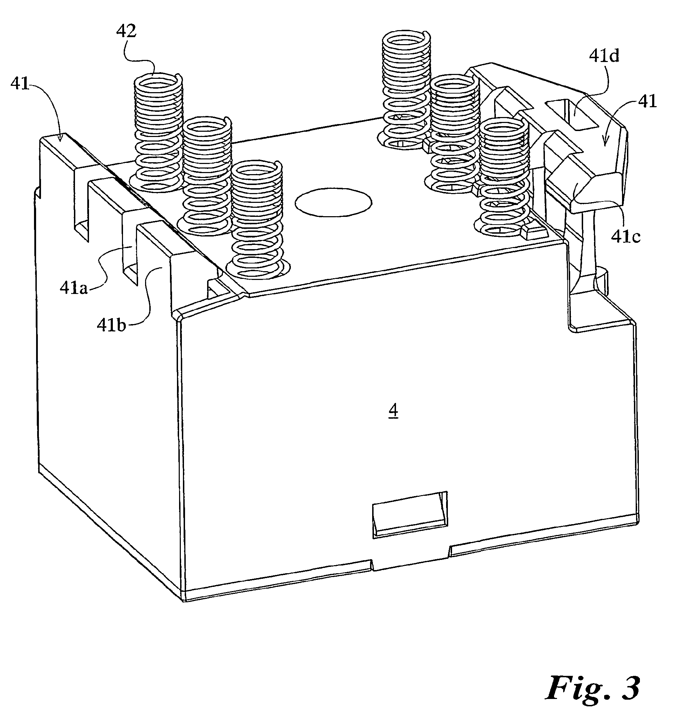

In Fig. 3 ist noch einmal das Koppelmodul 4 separat dargestellt.

## Patentansprüche

1. Elektrische Anordnung umfassend ein Befehls- und/oder Meldegerät mit einem Frontelement (6), einem Befestigungsadapter (10) und mindestens einem über den Befestigungsadapter (10) mit dem Frontelement (6) mechanisch verbindbaren Funktionselement (8), wobei jedes Funktionselement (8) Kabeleinführöffnungen zu Anschlussstellen für eine konventionelle Verdrahtung aufweist,
**gekennzeichnet durch**
ein Koppelmodul (4) welches aufweist:
eine Logikeinheit zur elektrischen Anbindung des Befehls- und/oder Meldegerätes an das Bussystem,
mechanische Verbindungsmittel (41) zur lösbaren Befestigung des Koppelmoduls (4) an dem mindestens einen Funktionselement (8), elektrische Verbindungsmittel (42) zur elektrischen Kontaktierung zwischen Koppelmodul (4) und dem mindestens einen Funktionselement (8),
sowie Busanschlußmittel (43) zur elektrischen Verbindung der Koppeleinheit (4) mit dem Bussystem.

2. Anordnung nach Anspruch 1, **dadurch gekennzeichnet, dass** die elektrischen Verbindungsmittel (42) der Koppeleinheit (4) durch Kontaktfedern gebildet sind.

3. Anordnung nach vorstehendem Anspruch, **dadurch gekennzeichnet, dass** jede Kontaktfeder kraftformschlüssig und lösbar im Gehäuse fixierbar ist.

4. Anordnung nach einem der vorstehenden Ansprüche, **dadurch gekennzeichnet, dass** die mechanischen Verbindungsmittel (41) der Koppeleinheit (4) durch Rastmittel ausgebildet sind.

5. Anordnung nach einem der vorstehenden Ansprüche, **dadurch gekennzeichnet, dass** die mechanischen Verbindungsmittel (41) der Koppeleinheit (4) mindestens einen feststehenden Hintergriff (41b) und mindestens einen federnd beweglich ausgebildeten Rastarm aufweisen.

6. Anordnung nach vorstehendem Anspruch, **dadurch gekennzeichnet, dass** mindestens zwei vorzugsweise drei jeweils über einen Freiraum (41a) voneinander beabstandete feststehende Hintergriffe (4 b) und zwei bzw. drei jeweils mit einem Hintergriff (41b) korrespondierende über einen Freiraum (41a) voneinander beabstandete Rastvorsprünge (41c) eines federnd beweglich ausgebildeten Rastarms vorhanden sind.

7. Anordnung nach Anspruch 5 oder 6, **dadurch gekennzeichnet, dass** der Rastarm Mittel (41d) - insbesondere eine schlitzförmige Aufnahme für den Eingriff eines Schraubendrehers - zur Betätigung beziehungsweise Verbiegung des Rastarms aufweist.

## Claims

1. Electrical arrangement comprising a command and/or signalling device having a front element (6), a fixing adaptor (10) and at least one functional element (8) which can be mechanically connected to the front element (6) by means of the fixing adaptor (10), each functional element (8) having cable insertion openings to contact points for conventional wiring, **characterised by**
a coupling module (4) having
a logic unit for electrically connecting the command and/or signalling device to the bus system,
mechanical connection means (41) for releasably connecting the coupling module (4) to the at least one functional element (8),
electrical connection means (42) for electrical contact between the coupling module (4) and the at least one functional element (8),
and bus connection means (43) for electrically connecting the coupling unit (4) to the bus system.

2. Arrangement according to claim 1, **characterised in that** the electrical connection means (42) of the coupling unit (4) are formed by spring contacts.

3. Arrangement according to the preceding claim, **characterised in that** each spring contact can be releasably fixed in the housing with an interlocking interference fit.

4. Arrangement according to any one of the preceding claims, **characterised in that** the mechanical connection means (41) of the coupling unit (4) are formed by locking means.

5. Arrangement according to any one of the preceding claims, **characterised in that** the mechanical connection means (41) of the coupling unit (4) have at least one fixed rear engagement means (41b) and at least one locking arm configured so as to be resiliently displaceable.

6. Arrangement according to the preceding claim, **characterised in that** there are provided at least two, preferably three, fixed rear engagement means (41b), each set apart from one another by a free space (41a), and two or three locking projections (41c), each corresponding to a rear engagement means (41b) and set apart from one another by a free space (41a), of a locking arm formed so as to be resiliently displaceable.

7. Arrangement according to either claim 5 or claim 6, **characterised in that** the locking arm has means (41d) - in particular a slot-shaped socket for engaging a screwdriver - for operating or twisting the locking arm.

## Revendications

1. Assemblage électrique, englobant un dispositif de commande et/ou de signalisation, avec un élément frontal (6), un adaptateur de fixation (10) et au moins un élément fonctionnel (8) pouvant être relié de manière mécanique à l'élément frontal (6) par l'intermédiaire de l'adaptateur de fixation (10), chaque élément fonctionnel (8) comportant des ouvertures d'insertion de câbles menant vers des points de raccordement en vue d'un câblage conventionnel, **caractérisé par**
un module de couplage (4), comportant :
une unité logique assurant la connexion électrique du dispositif de commande et/ou de signalisation au système de bus ;
des moyens de raccordement mécaniques (41) assurant la fixation amovible du module de couplage (4) sur au moins un élément fonctionnel (8),
des moyens de raccordement électriques (42) assurant l'établissement d'un contact électrique entre le module de couplage (4) et le au moins un élément fonctionnel (8) ;
ainsi que des moyens de raccordement de bus (43) assurant la liaison électrique de l'unité de couplage (4) avec le système de bus.

2. Assemblage selon la revendication 1, **caractérisé en ce que** les moyens de raccordement électriques (42) de l'unité de couplage (4) sont constitués par des ressorts de contact.

3. Assemblage selon la revendication précédente, **caractérisé en ce que** chaque ressort de contact peut être fixé de manière dynamique et amovible dans le boîtier.

4. Assemblage selon l'une des revendications précédentes, **caractérisé en ce que** les moyens de raccordement mécaniques (41) de l'unité de couplage (4) sont constitués par des moyens d'encliquetage.

5. Assemblage selon l'une des revendications précédentes, **caractérisé en ce que** les moyens de raccordement mécaniques (41) de l'unité de couplage (4) comportent au moins un moyen d'accrochage fixe (41b) et au moins un bras d'encliquetage configuré de sorte à pouvoir se déplacer de manière élastique.

6. Assemblage selon la revendication précédente, **caractérisé en ce qu'**il comporte au moins deux, de préférence trois moyens d'accrochage fixes (41b), espacés respectivement par un espace libre (41a) et deux, respectivement trois saillies d'encliquetage (41c) d'un bras d'encliquetage configuré de sorte à pouvoir se déplacer de manière élastique, espacées par un espace libre (41a), correspondant respectivement à un moyen d'accrochage (41b).

7. Assemblage selon les revendications 5 ou 6, **caractérisé en ce que** le bras d'encliquetage comporte des moyens (41d), en particulier un moyen de réception en forme de fente pour l'engagement d'un tournevis, destinés à l'actionnement ou à la déformation du bras d'encliquetage.
